# EUROPEAN PATENT SPECIFICATION

(11) **EP 1 025 583 B1**
(45) Date of publication and mention of the grant of the patent: **14.06.2006**
(21) Application number: 98954322.8
(22) Date of filing: 30.09.1998
(51) Int. Cl.: H01L 21/768, H01L 21/3105

(54) **IMPROVED GAPFILL OF SEMICONDUCTOR STRUCTURE USING DOPED SILICATE GLASSES WITH MULTI-STEP DEPOSITION/ANNEAL PROCESS**
VERBESSERTES LÜCKENFÜLLUNGSVERFAHREN FÜR HALBLEITERSTRUKTUR UNTER VERWENDUNG VON DOTIERTEM SILIKATGLAS MIT MEHRSTUFIGER ABSCHEIDUNG/AUSHEILBEHANDLUNG
PROCEDE AMELIORE DE REMPLISSAGE D'ESPACES DE STRUCTURES DE SEMICONDUCTEURS A L'AIDE DE VERRES DE SILICATE DOPE SELON UNE PROCEDURE EN PLUSIEURS ETAPES DE DEPOT/RECUIT

(30) Priority: 30.09.1997 US 940528
(43) Date of publication of application: 09.08.2000
(73) Proprietor: Infineon Technologies AG, 81669 München (DE)
(72) Inventor: KIRCHHOFF, Markus, D-01458 Ottendorf-Okrilla (DE); ILG, Matthias, Richmond, VA 23220 (US)
(74) Representative: Patentanwälte Westphal, Mussgnug & Partner
(86) International application number: PCT/EP1998/006279
(87) International publication number: WO 1999/017358

(56) References cited:
- WO-A-97/24755
- PATENT ABSTRACTS OF JAPAN vol. 013, no. 295 (E-783), 7 July 1989 & JP 01 076727 A (NEC CORP), 22 March 1989
- PATENT ABSTRACTS OF JAPAN vol. 017, no. 636 (E-1464), 25 November 1993 & JP 05 206111 A (FUJITSU LTD), 13 August 1993
- "HIGH ASPECT RATIO FILL BY MULTIPLE DEPOSITIONS AND REFLOWS" IBM TECHNICAL DISCLOSURE BULLETIN, vol. 33, no. 1B, 1 June 1990, page 182/183 XP000122857

## Description

### BACKGROUND OF THE INVENTION

The invention relates to device fabrication. In device fabrication, insulating, semiconducting, and conducting layers are formed on a substrate. The layers are patterned to create features and spaces, forming devices, such as transistors, capacitors, and resistors. These devices are then interconnected to achieve a desired electrical function, producing an integrated circuit (IC) .

Doped silicate glass is used as, for example, an insulating layer between conductive or semiconductive layers in the manufacture of ICs. In particular, the use of doped silicate glass such as borophosphosilicate glass (BPSG) is attractive due to its ability to reflow when annealed at a sufficiently high temperature. As such, doped silicate glass can be used to fill relatively small gaps without voids. As the term is used herein, the term "gap" refers to any generic nonplanar feature on a given surface and may include such features as trenches or spaces between gates of transistors.

Conventionally, BPSG is formed by various chemical vapor deposition (CVD) techniques. The BPSG is deposited at a relatively low temperature of about 400°C. After deposition, the substrate is heated to a high enough temperature to cause the glass to soften. For example, annealing the BPSG (concentration of 2 and P of about 4 wt'-. each) at a temperature of 800°C for about 30 minutes can fill structures as narrow as 0.25 um with aspect ratios of up to 3:1 without voids.

Patent Abstracts of Japan for Publication No. 01076727 discloses a method of fabricating a semiconductor structure, the method including depositing a BPSG film at a first temperature and annealing the film at a higher temperature, 900°C, by lamp heating. WO-A-97/24755 discloses a method of fabricating a semiconductor structure utilizing doped silicate glass on a substrate of a wafer. The method includes depositing a heavily-doped silicate glass and a lightly-doped silicate glass at the same deposition temperature, at which temperature the heavily-doped silicate glass flows upon being deposited.

The dopant concentration of the doped silicate glass affects its reflow or melting temperature. The higher the dopant concentration, the lower the reflow temperature and vice-versa. Thus, increasing the dopant concentration improves the glass' ability to fill gaps at a given temperature. Generally, it is desirable to have as high a dopant concentration as possible to enable filling of small gaps with a lower thermal budget. However, if the dopant concentration exceeds an upper limit, the dopants tend to precipitate and form acid crystals on the surface. Such surface crystals adversely affect the reliability and characteristics of subsequently formed layers. Typically, the upper limit of dopant concentration is about 11%. Of course, this limit may vary depending on the type of doped silicate glass and deposition conditions.

As dimensions continue to decrease in advance IC designs, the doped silicate glass is required to fill narrower structures with higher aspect ratios. Due to the inherent upper limit in the dopant concentration of the doped silicate glass, a higher temperature anneal of longer duration is required in order to satisfy the needs of advance IC designs. However, such an anneal typically exceeds the allowable thermal budget, resulting in a nonexisting manufacturing process window.

From the above discussion, ic is desirable to provide filling of narrow structures with high aspect ratios having a manufacturable process window.

### SUMMARY OF THE INVENTION

The invention as defined in the claim relates to improved gap fill of narrow spaces in the fabrication of integrated circuits. Improved gap fill is achieved by providing a multi-step deposition/anneal process of a doped silicate glass. This includes depositing a doped silicate glass layer having a thickness less than a desired thickness at about the reflow temperature and annealing the layer to cause it to flow. The anneal improves gap fill, thereby reducing the aspect ratio of the narrow spaces. The deposition and anneal steps are repeated until the doped silicate glass reaches the desired thickness.

### BRIEF DESCRIPTION OF THE INVENTION

Fig. 1 shows a cross-section of an integrated circuit with device features separated by narrow spaces;
Fig. 2 shows a device layer in accordance with one embodiment that provides improved gap fill of the narrow spaces; and
Figs. 3a-b show a CVD reactor for forming the device layer with improved gap fill characteristics.

### DETAILED DESCRIPTION OF THE INVENTION

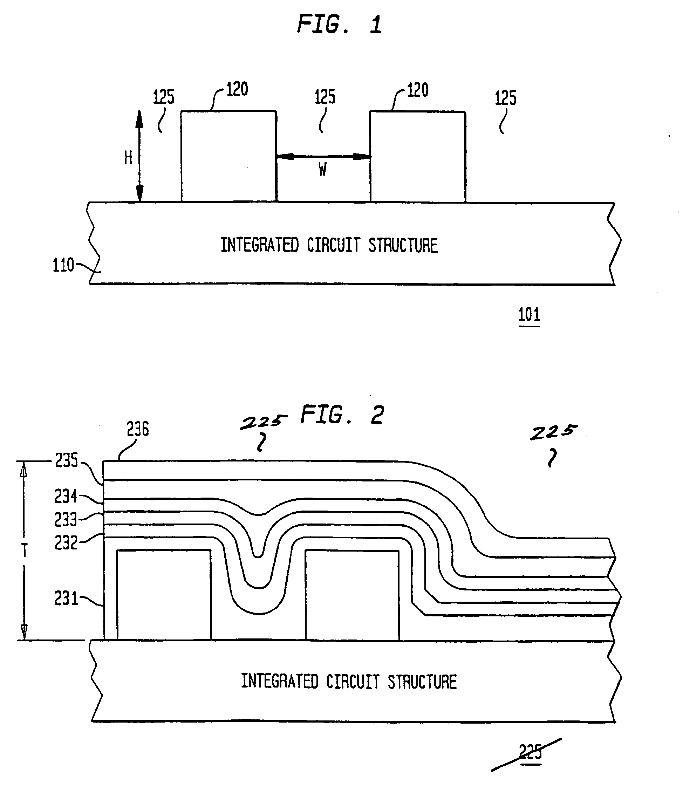

The invention relates to doped silicate glass as used in, for example, an insulating layer in IC fabrication. Referring to Fig. 1, a cross-section of a portion of an IC structure formed on a substrate 101 is shown. The IC structure, which is not shown in detail, is, for example, a portion of a memory IC including a random access memory (RAM), a dynamic RAM (DRAM), a synchronous DRAM (SDRAM), a static RAM (SRAM), or a read only memory (ROM). Alternatively, the IC structure may be a logic IC such as a programmable logic array (PLA), an application specific IC (ASIC), a merged DRAM-logic IC (embedded DRAM) or any other logic circuit.

Typically, numerous ICs are fabricated on a semiconductor substrate, such as a silicon wafer, in parallel. After processing, the wafer is diced in order to separate the ICs into a plurality of individual chips. The chips are then packaged into final products for use in, for example, consumer products such as computer systems, cellular phones, personal digital assistants (PDAs), and other electronic products.

The substrate 101 is, for example, a silicon wafer. Other substrates, such as silicon on insulator (SOI), silicon on sapphire (SOS), germanium, gallium arsenide, and group III-V compounds, are also useful. The major surface of the substrate is not critical and any suitable orientation such as a (100), (110), or (111) is useful. The substrate, for example, includes a plurality of devices such as trench capacitors (not shown) formed therein. Such trench capacitors serve as storage capacitors for DRAM cells. Formation of the trench capacitors is achieved using conventional techniques.

As shown, device features 120 are provided on the surface of the substrate. The device structures, for example, are gates of transistors. In one embodiment, the transistors represent wordlines that connect a plurality of memory cells in a memory array.

Typically, the gates include a gate oxide layer, a doped poly layer, and a cap nitride layer. In some embodiments, the poly layer may comprise a polycide layer that includes a layer of silicide over a doped poly layer. A nitride liner is provided over the device structures, serving as an etch stop for borderless contact formation.

The device structures are separated by gaps 125, creating an uneven surface topology on the substrate surface. The aspect ratio of the gaps is defined by the height H of the device structures over the width W of the space separating them.

In accordance with the invention, a technique for forming a doped silicate glass layer over uneven surface topography is provided. The invention enables the formation of doped silicate glass that fills small gaps having relatively high aspect ratios without voids and surface crystals while requiring a lower thermal budget that results in a greater manufacturable process window.

The doped silicate glass has a predetermined thickness. The predetermined thickness depends on the specific application. For example, when used as an interlevel dielectric layer, the thickness of the doped silicate glass is sufficient to provide isolation between the device structures and the overlying conductive layer. The deposited thickness should take into account the polish step used to planarize the layer. Typically, for a 256 Megabit DRAM employing 0.25 um groundrule (GR), the thickness of the doped silicate glass is about 0.75-1.2 um. Of course the actual thickness may be optimized for different GRs and applications.

Referring to Fig. 2, a doped silicate glass layer having a predetermined thickness T is formed in accordance with the invention. The doped silicate glass in one embodiment comprises BPSG. BSG or other doped silicate glass is also useful. In accordance with the invention, a multi-step deposition/anneal process is employed. The silicate glass layer is formed by at least two deposition/anneal steps. Preferably, the silicate glass is formed by about 2-10 deposition/anneal steps. The number of deposition/anneal steps may vary depending on design parameters, such as the aspect ratio of the features to be filled.

In the illustrative embodiment, the doped silicate glass is formed by six deposition/anneal steps. A partial layer 231 is formed in a first deposition step followed by an anneal step. In one embodiment, the doped silicate glass is deposited at a temperature sufficient to cause the deposited glass to flow. The temperature, for example, is in the range about 600-900°C, preferably about 720-870°C, more preferably at about 800°C. After deposition, the doped silicate glass is annealed.

According to the invention, the glass is annealed at the deposition temperature since the doped silicate glass is deposited at a sufficiently high temperature to cause reflow. Ambients such as H₂O, O₂, or N₂/O₂ mixture is useful. The anneal is adequate to cause the doped silicate glass to flow to the bottom of the gap. The anneal is advantageously performed in the deposition tool by switching off the chemicals that form the layer. Since the glass is deposited at the reflow temperature, the anneal that is required is relatively short. For example, the anneal is about between about 20s-1min. Shorter or longer anneals are useful, depending on the aspect ratio of the feature and material used.

The deposition/anneal process is repeated to form subsequent layers 232, 233, 234, 235, and 236. As the glass flows to the bottom, the aspect ratio of the gap 225 is decreased. With each subsequent deposition and anneal, the glass flows to the bottom of the gap. This further decreases the aspect ratio of the gap, making it easier to fill and planarize the structure. The deposition continues until the doped silicate glass reaches a desired thickness. Thereafter, a CMP planarizes the surface, resulting in a planar doped silicate glass layer having a predefined thickness.

Although the layers, as shown, are relatively equal in thickness, it is not critical to the invention. By providing a multi-step deposition/anneal process, the aspect ratio of the structure to be filled is reduced with each deposition and anneal step, producing a structure that is easier to fill.

The doped silicate glass layers can be formed using various chemical vapor deposition (CVD) techniques. For example, low pressure, thermal activated, plasma activated, or other CVD are useful in forming the silicate layers.

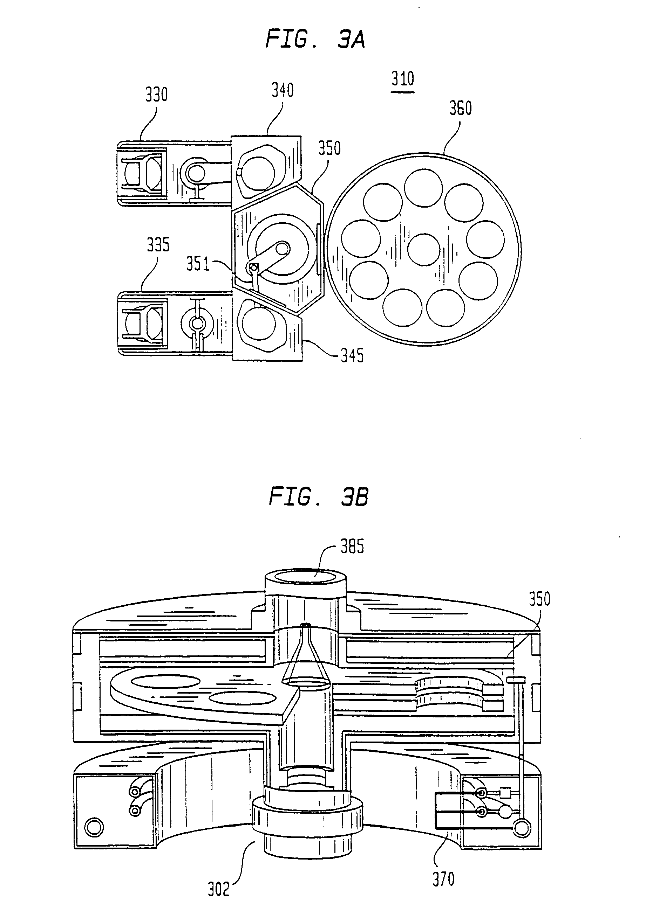

In one embodiment, the doped silicate glass layers are formed using a low pressure chemical vapor deposition (LPCVD) process. Referring to Fig. 3a, a simplified top view of a CVD reactor 310 is shown. The reactor is, for example, a DSM^{™} 9800 that is manufactured by Lam Research Corporation of Fremont. The Lam Integrity DSM 9800 is described in US Patent 4,976,996 issued to Monkowski et al. It should be noted that the CVD reactor shown is merely illustrative and variations thereof are also useful.

As shown, reactor 310 comprises wafer cassette storage bays 330 and 335, loadlock units 340 and 345, transfer chamber 350, and reaction chamber 360. The cassette storage bays store a cassette, such as those used for holding and storing a plurality of wafers in conventional device fabrication. The wafers in the cassettes are transferred to the respective load lock units by wafer transfer arms 331 and 332. The transfer chamber 150 includes a wafer loading arm 351. The wafer loading arm removes a wafer from either loadlock 340 or loadlock 345 and places it in a wafer slot 361 of a rotating platen 365 in the reaction chamber. Illustratively, the platen comprises a plurality of wafer slots. Wafers are loaded into the other slots by rotating the platen to the appropriate position.

Fig. 3b shows the reaction chamber in greater detail. As shown, the reaction chamber comprises platen 380. The platen rotates around a hub 302 (the direction of rotation of platen 380 is arbitrary). Illustratively, the platen includes a plurality of slots for placement of a wafer therein. Typically, the slots are depressed such that the top surface of the wafer, when placed therein, is substantially planar with the surface of the platen.

A plurality of injectors 350 is located at the circumference of the reaction chamber. Feed lines 370 connected to the injectors provide materials from a supply source for the reaction. The number of feed lines depends on the number of different types of materials used for forming the layer. The materials are mixed and delivered into the reaction area of the chamber by the injectors.

An exhaust port 385 passes excess materials and by-products of the reaction out of the reaction chamber. The exhaust port is formed by, for example, an interior passageway through hub 302 for venting gases from the reactor chamber. As such, the direction of the flow of the chemistry is from injectors toward the center. Alternatively, reversing the direction of chemistry flow is also useful. Reversing the flow is achieved by locating the injectors at the center of the chamber and the exhaust vents at the circumference of the chamber.

The reactor is essentially isothermal. In one embodiment, heaters (not shown for ease of illustration), which may be resistive, are strategically located throughout the reactor chamber to compensate for any heat loss. In this manner, a constant temperature may be maintained during the deposition process. For example, there may exist an inner heater proximate to exhaust port 385 to compensate for the heat loss there through. An outer heater surrounding the reactor chamber compensates for the heat loss to the outside world. Preferably, there is also provided a resistive middle heater, which radiates heat to the entire chamber to maintain a suitable wafer temperature during deposition.

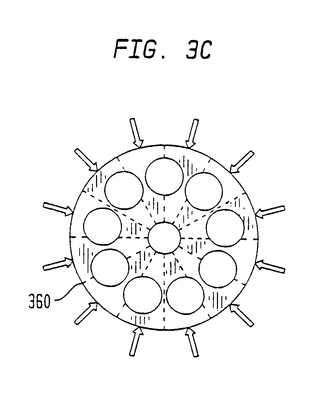

Referring to Fig. 3c, an illustrative reaction chamber is provided with twelve injectors (depicted by arrows). Providing the reaction chamber with a fewer or a greater number of injectors is also useful. The injectors are equally spaced apart at the periphery of the reaction chamber. Each injector therefore defines a 30° injection area in the reactor chamber, as delineated by the dotted lines. In other words, each injector injects into a different sector of the reactor. Such an injection scheme is referred to as a segmented delivery system.

In operation, source materials for the silicate glass, which typically are in gaseous form, are injected into the reaction chamber via the injectors. The source material flows from the injectors toward the center of the reaction chamber. Simultaneously, the platen supporting the wafers is rotated, moving the wafers through the injected source materials. As the source materials contact the wafer surfaces, they chemically react to deposit doped silicate glass thereon. Excess source materials and their by-products are exhausted through the exhaust port.

In operation, source materials for the silicate glass, which typically are in gaseous form, are injected into the reaction chamber via the injectors. The source material flows from the injectors toward the center of the reaction chamber. Simultaneously, the platen supporting the wafers is rotated, moving the wafers through the injected source materials. As the source materials contact the wafer surfaces, they chemically react to deposit doped silicate glass thereon. Excess source materials and their by-products are exhausted through the exhaust port.

In accordance with one embodiment of the invention, source materials that make up BPSG are injected into the reaction chamber. In one embodiment, two source materials or chemistries are injected to form BPSG. The first chemistry comprises, for example, TEB/TEOS/O_{2/}N₂. The TEOS (tetraethoxysilane) is the source of silicon, TEB (triethyl borate) provides the source of boron (B) dopant atoms, and O₂ and N₂ are carrier gases. The second source material comprises a phosphine chemistry such as PH₃/O₂/N₂. PH₃ (phosphine) provides the source of phosphorus (P) dopant atoms, and O₂ and N₂ are oxidation and carrier gases. Other chemistries used in forming BPSG are also useful.

The two chemistries are, for example, delivered into the reaction chamber via alternating injectors. The formation of the BPSG layer is achieved using conventional process conditions, such as those described in Tedder et al., Appl. Phys. Lett. 62, p. 699 (1993).

In one embodiment, the dopant concentration is sufficient to achieve filling of gaps without formation of surface crystals. The concentration of B and P is about 5-11 wt%. Typically, the concentration of B and P for the BPSG layer is about 3-6 wt% each, but any concentration combinations of B and P which does not cause surface crystal growth is useful. Of course, the actual concentration depends on the design requirement, such as gap fill and gettering characteristics.

The temperature of the reaction chamber is greater than about the melting point of the doped silicate glass. As discussed, the melting point of the doped silicate glass depends on the actual dopant concentration. Typically, the deposition temperature is about 600-900°C, preferably about 720-870°C, and more preferable about 800°C. The pressure in the reaction chamber is about 0.5 to 5 Torr (1Torr=133Pa). The platen is rotated at less than or equal to about 20 revolutions per minutes (rpm), preferably about 1-5 rpm, more preferably less than or equal to about 5 rpm.

In accordance with the invention, the deposition and anneal is advantageously performed in the same reaction chamber. For example, the formation of doped silicate glass of a predetermined thickness can be divided into n deposition steps, where n is greater than 2. After each deposition step, injection of the source materials, except for nitrogen and/or oxygen, into the chamber is terminated by closing the valves. Thus, the deposited doped silicate glass is annealed at the deposition temperature in a nitrogen and/or oxygen ambient.

Due to the fact that the deposition is performed at a temperature equal to or greater than the melting point of the doped silicate glass, the anneal to achieve reflow is relatively short. As such, the total deposition time of the multi-step deposition/anneal process remains relatively the same as or shorter than the conventional single deposition/anneal process.

Alternatively, other chemistries are used to form other doped layers. For example, TEB/0₂/N₂ and TEOS/O₂/N₂ chemistries are used to form B doped layer or PH₃/0₂/N₂ and TEOS/0₂/N₂ chemistries are used to form B doped layers. Other dopants which lower the melting point of the doped silicate glass are also useful.

While this invention has been described in terms of several illustrative embodiments, there are alterations, permutations, and equivalents which fall within the scope of this invention. It should also be noted that there are many alternative ways of implementing the processes of the present invention. It is therefore intended that the following appended claim be interpreted as including all such alterations, permutations, and equivalents which fall within the scope of the present invention.

## Claims

1. A method of fabricating an integrated circuit comprising: providing a substrate comprising high aspect ratio device features separated by narrow spaces;
a) depositing a doped silicate glass layer having a thickness less than a desired thickness, the doped silicate glass being deposited at a temperature that is sufficient to cause reflow;
b) without deposition, annealing the doped silicate glass layer at said temperature, wherein the anneal causes the doped silicate glass to further flow and fill the spaces partially so as to reduce the aspect ratio of the spaces; and
repeating steps a and b an n number of times to form the doped silicate glass having the desired thickness.

## Patentansprüche

1. Verfahren zur Herstellung eines integrierten Schaltkreises, das aufweist:
Bereitstellen eines Substrats, das Bauelementstrukturen mit einem hohen Aspektverhältnis, die durch Zwischenräume getrennt sind, aufweist;
a) Abscheiden einer dotierten Silikatglasschicht mit einer Dicke, die kleiner als eine gewünschte Dicke ist, wobei das dotierte Silikatglas bei einer Temperatur abgeschieden wird, die ausreichend ist, um ein Aufschmelzen zu bewirken;
b) Aufheizen der dotierten Silikatglasschicht ohne Abscheidung bei dieser Temperatur, wobei das Aufheizen bewirkt, dass das dotierte Silikatglas weiterfließt und Zwischenräume teilweise füllt, so dass das Aspektverhältnis reduziert wird, und
Wiederholen der Schritte a und b n-mal, um das dotierte Silikatglas mit der gewünschten Dicke zu erzeugen.

## Revendications

1. Procédé de fabrication de circuit intégré avec fourniture d'un substrat comprenant des dispositifs à reliefs de grand rapport d'aspect séparés par des espaces étroits,
selon lequel
a) on dépose une couche de verre au silicium dopé ayant une épaisseur inférieure à une épaisseur souhaitée, le verre au silicium dopé étant déposé à une température suffisante pour entraîner l'écoulement,
b) sans dépôt, on recuit à cette température la couche de verre au silicium dopé, le recuit faisant que le verre au silicium dopé s'écoule davantage et remplisse partiellement les espaces de façon à réduire le rapport d'aspect des espaces, et
c) on répète les étapes a) et b) un nombre n de fois pour former le verre au silicium dopé ayant l'épaisseur désirée.
